# EUROPEAN PATENT APPLICATION

(11) **EP 4 375 400 A1**
(43) Date of publication of application: **29.05.2024**
(21) Application number: 23211660.8
(22) Date of filing: 23.11.2023
(51) Int. Cl.: C30B 25/14, C23C 16/40, C23C 16/455, C30B 25/16, C30B 29/22, H01L 21/00

(54) **CRYSTALLINE INZNO OXIDE SEMICONDUCTOR, METHOD OF FORMING THE SAME, AND SEMICONDUCTOR DEVICE INCLUDING THE CRYSTALLINE INZNO OXIDE SEMICONDUCTOR**

(30) Priority: 25.11.2022 KR 20220160796
(71) Applicant: Samsung Electronics Co., Ltd., Suwon-si, Gyeonggi-do 16677 (KR); IUCF-HYU (INDUSTRY-UNIVERSITY COOPERATION FOUNDATION HANYANG UNIVERSITY), Seoul 04763 (KR)
(72) Inventor: LEE, Kwanghee, 16678 Suwon-si (KR); PARK, Jinseong, 16678 Suwon-si (KR); KIM, Sangwook, 16678 Suwon-si (KR); KIM, Hyemi, 16678 Suwon-si (KR); RYU, Seonghwan, 16678 Suwon-si (KR)
(74) Representative: Elkington and Fife LLP

(57) **Abstract**

Provided are a crystalline InZnO oxide semiconductor, a method of forming the same, and a semiconductor device including the crystalline InZnO oxide semiconductor. The crystalline InZnO oxide semiconductor includes an oxide including In and Zn, wherein in Inductively Coupled Plasma-Mass Spectrometry (ICP-MS) analysis, a content of In among In and Zn is about 30 at% or more and about 75 at% or less, and the crystalline InZnO oxide semiconductor has a peak showing crystallinity at a 2-theta value between about 32.3 degrees and about 33.3 degrees in X-ray diffraction (XRD) analysis.

## Description

### FIELD OF THE INVENTION

The disclosure relates to a crystalline InZnO oxide semiconductor, a method of forming the same, and a semiconductor device including the crystalline InZnO oxide semiconductor.

### BACKGROUND OF THE INVENTION

Silicon-based memory devices or logic devices have reached the limit of high integration, and thus, there is a need to reduce the off-current as a channel length of several tens or several nanometers is required. In addition, in order to clearly distinguish between on and off states, a subthreshold swing (SS), an on/off ratio, or the like should be improved. An oxide semiconductor transistor is a semiconductor device that has the required characteristics described above (low off-current, low subthreshold swing, and high on/off ratio).

Oxide semiconductors are transparent semiconductor materials having a wide band gap of about 3.0 eV or more, and have been applied to display driving devices. Recently, due to the excellent characteristics described above, a method of using an oxide semiconductor device for a memory device or a logic device has been proposed.

### SUMMARY OF THE INVENTION

Provided are a crystalline InZnO oxide semiconductor, a method of forming the same, and a semiconductor device including the crystalline InZnO oxide semiconductor.

Additional aspects will be set forth in part in the description which follows and, in part, will be apparent from the description, or may be learned by practice of the presented embodiments of the disclosure.

According to an embodiment of the disclosure, a crystalline InZnO oxide semiconductor may include an oxide including In and Zn. In Inductively Coupled Plasma-Mass Spectrometry (ICP-MS) analysis, a content of In among In and Zn may be about 30 at% or more and about 75 at % or less, and in an X-ray diffraction (XRD) analysis, the crystalline InZnO oxide semiconductor may have a peak showing crystallinity at a 2-theta value between about 32.3 degrees and about 33.3 degrees.

In some embodiments, a content of In among In and Zn may be about 32 at% or more.

In some embodiments, a content of In among In and Zn may be about 33 at% or more.

In some embodiments, a content of In among In and Zn may be about 35 at% or more.

In some embodiments, a content of In among In and Zn may be about 70 at% or less.

In some embodiments, a content of In among In and Zn may be about 65 at% or less.

According to an embodiment of the disclosure, a method of forming a crystalline InZnO oxide semiconductor may include co-depositing In and Zn on a substrate by using atomic layer deposition (ALD), where a ratio of a deposition cycle of In with respect to a deposition cycle of Zn may be about 1 or more and about 8 or less, and in an X-ray diffraction (XRD) analysis, the crystalline InZnO oxide semiconductor may have a peak showing crystallinity at a 2-theta value between about 32.3 degrees and about 33.3 degrees.

In some embodiments, a ratio of a deposition cycle of In with respect to a deposition cycle of Zn is about 1.5 or more.

In some embodiments, a ratio of a deposition cycle of In with respect to a deposition cycle of Zn is about 2 or more.

In some embodiments, a ratio of a deposition cycle of In with respect to a deposition cycle of Zn is about 6 or less.

In some embodiments, a ratio of a deposition cycle of In with respect to a deposition cycle of Zn is about 5 or less.

In some embodiments, a ratio of a deposition cycle of In with respect to a deposition cycle of Zn is about 4 or less.

In some embodiments, in ICP-MS analysis of the crystalline InZnO oxide semiconductor, a content of In among In and Zn may be about 30 at% or more and about 75 at % or less.

In some embodiments, in the co-deposition process of In and Zn, a temperature of the substrate may be about 200 °C or more and about 350 °C or less.

In some embodiments, in the co-deposition process of In and Zn, a temperature of the substrate may be about 200 °C or more and about 300 °C or less.

According to an embodiment of the disclosure, a semiconductor device may include a substrate, a channel layer on the substrate and including a crystalline InZnO oxide semiconductor, a gate electrode on the channel layer, and a source electrode and a drain electrode on both sides of the channel layer, respectively. In ICP-MS analysis of the crystalline InZnO oxide semiconductor, a content of In among In and Zn may be about 33 at% or more and about 75 at % or less. In an X-ray diffraction (XRD) analysis, the crystalline InZnO oxide semiconductor may have a peak showing crystallinity at a 2-theta value between about 32.3 degrees and about 33.3 degrees.

In some embodiments, the semiconductor device may further include a gate insulating layer between the channel layer and the gate electrode.

In some embodiments, the channel layer may be parallel to the substrate. The gate electrode may be above or under the channel layer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a graph showing results of X-ray diffraction (XRD) of InZnO thin films manufactured according to respective temperatures of a substrate when depositing an InZnO thin film on the substrate by an atomic layer deposition (ALD) process;
FIG. 2 is a graph showing I-V characteristics of transistors in which InZnO thin films manufactured according to the respective temperatures of the substrate illustrated in FIG. 1 are used as a channel;
FIG. 3 is a graph showing XRD analysis results of InZnO thin films manufactured according to a In:Zn deposition cycle ratio;
FIG. 4 is a graph showing a change in a carrier concentration, Hall mobility, and resistivity of InZnO thin films manufactured according to a In:Zn deposition cycle ratio;
FIG. 5 is a graph showing I-V characteristics of transistors in which InZnO thin films manufactured according to the In:Zn deposition cycle ratio are used as a channel;
FIG. 6 illustrates a semiconductor device according to an embodiment;
FIG. 7 illustrates a semiconductor device according to an embodiment;
FIG. 8 illustrates an electronic device including a semiconductor device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Reference will now be made in detail to embodiments, examples of which are illustrated in the accompanying drawings. In the drawings, like reference numerals refer to like elements throughout and sizes of constituent elements may be exaggerated for convenience of explanation and the clarity of the specification. In this regard, embodiments described herein may have different forms and should not be construed as being limited to the descriptions set forth herein.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element, unless otherwise defined, other elements are not excluded from the part and the part may further include other elements.

The use of the terms "a" and "an" and "the" and similar referents are to be construed to cover both the singular and the plural. The steps of all methods described herein can be performed in any suitable order unless otherwise indicated herein or otherwise clearly contradicted by context, and are not limited to the described order.

Also, in the specification, the term "... units" or "... modules" denote units or modules that process at least one function or operation, and may be realized by hardware, software, or a combination of hardware and software.

Furthermore, the connecting lines, or connectors shown in the various figures presented are intended to represent example functional relationships and/or physical or logical couplings between the various elements. It should be noted that many alternative or additional functional relationships, physical connections or logical connections may be present in a practical device.

The use of any and all examples, or example language (e.g., "such as") provided herein, is intended merely to better illuminate the disclosure and does not pose a limitation on the scope of the disclosure unless otherwise claimed.

Oxide semiconductors are transparent semiconductor materials having a wide band gap of about 3.0 eV or more, and may be applied to display driving devices. In addition, oxide semiconductors have excellent characteristics such as low off-current, low subthreshold swing, and a high on/off ratio, and thus may be used in memory devices or logic devices.

An atomic layer deposition (ALD) method is used to form an oxide semiconductor thin film, and by this ALD method, for example, a multi-component oxide semiconductor thin film such as InGaZnO, InZnO, InGaO, etc. may be manufactured.

InZnO, which is used as an electrode material because of its excellent electrical conductivity among oxide semiconductors, may be used in various ways, from conductors to semiconductors, depending on the In:Zn composition ratio. In general, indium oxide has an In₂O₃ molecular structure and a cubic crystal structure, and zinc oxide has ZnO molecular structure and a hexagonal crystal structure. Thus, when forming an InZnO thin film by mixing In and Zn, an amorphous thin film is generally formed due to a mismatch in a crystal structure.

In embodiments below, a crystalline InZnO oxide semiconductor may be formed in a certain elementary composition ratio range of In and Zn. In detail, the crystalline InZnO oxide semiconductor has a content of In that is greater than about 33 at% and less than about 75 at% among In and Zn in Inductively Coupled Plasma-Mass Spectrometry (ICP-MS) analysis, and has a peak showing crystallinity at a 2-theta value between about 32.3 degrees and about 33.3 degrees in X-ray diffraction (XRD) analysis. By using a crystalline InZnO oxide semiconductor thin film as above, a semiconductor device having excellent characteristics may be manufactured.

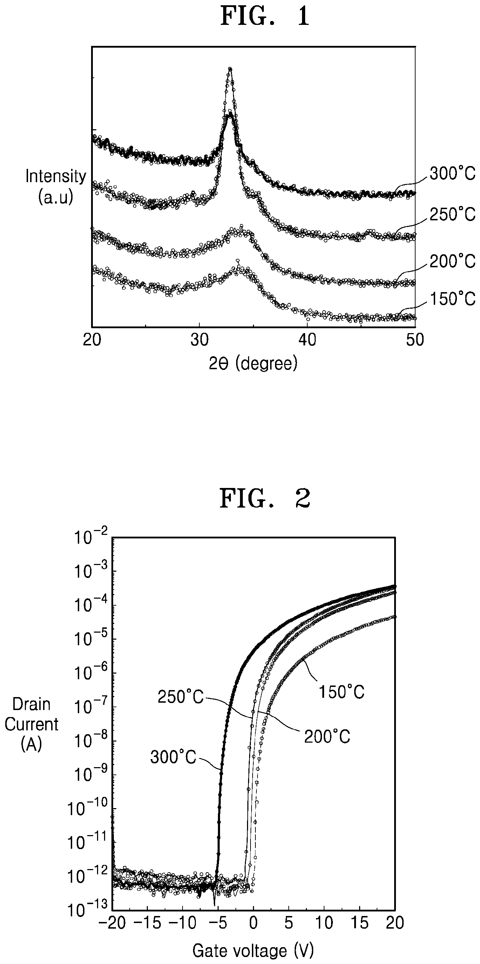

FIG. 1 is a graph showing results of XRD of InZnO oxide semiconductor thin films manufactured according to respective temperatures of a substrate when depositing an InZnO oxide semiconductor thin film on the substrate by an ALD process. In an ALD process, Os was used as an oxidant, and a In:Zn deposition cycle ratio (i.e., In deposition cycle: Zn deposition cycle) was set to 1:1.

FIG. 1 shows XRD analysis results of an InZnO oxide semiconductor thin film formed while increasing a substrate temperature, which is a process temperature, by 50 °C, from 150 °C to 300 °C. Referring to FIG. 1, an amorphous InZnO oxide semiconductor thin film was formed when the substrate temperature was less than 200 °C, but at the substrate temperature of 250 °C and 300 °C, peaks showing crystallinity were clearly found. In addition, since a relatively highest peak intensity appears at the substrate temperature of 250 °C, it is confirmed that an InZnO oxide semiconductor thin film having greatest crystallinity was formed at the substrate temperature of 250 °C.

As described above, when forming an InZnO oxide semiconductor thin film by using an ALD process, a crystalline InZnO oxide semiconductor thin film may be formed when the substrate temperature is about 200 °C or more and about 350 °C or less (for example, about 300 °C or less).

FIG. 2 is a graph showing I-V characteristics of transistors in which InZnO oxide semiconductor thin films manufactured according to the respective temperatures of the substrate, illustrated in FIG. 1, are used as a channel. Here, SiO₂ having a thickness of 100 nm was used as a gate insulating layer of each transistor.

Referring to FIG. 2, a saturation current increases as the substrate temperature increases from 150 °C to 250 °C. Accordingly, this shows that the crystalline InZnO oxide semiconductor thin film may have better transistor characteristics than an amorphous InZnO oxide semiconductor thin film.

Table 1 below shows an In:Zn elementary composition ratio according to an In:Zn deposition cycle ratio in the InZnO oxide semiconductor thin film manufactured by the ALD process when the substrate temperature is 250 °C, expressed based on atomic percent (at%). Here, the In:Zn elementary composition ratio in the InZnO oxide semiconductor thin film is a result measured by ICP-MS analysis.

**[Table 1]**

| Cycle ratio | At % | |
|---|---|---|
| | In | Zn |
| In:Zn = 1:1 | 0.329 | 0.671 |
| In:Zn = 2:1 | 0.469 | 0.531 |
| In:Zn = 4:1 | 0.622 | 0.378 |
| In:Zn = 8:1 | 0.746 | 0.254 |
| In:Zn = 12:1 | 0.803 | 0.197 |

Referring to Table 1, when the In:Zn deposition cycle ratio is 1:1, 2:1, 4:1, and 8:1, respectively, the In:Zn elementary composition ratio in the InZnO oxide semiconductor thin film may be approximately 1:2, 1:1, 3:2, and 3:1, respectively.

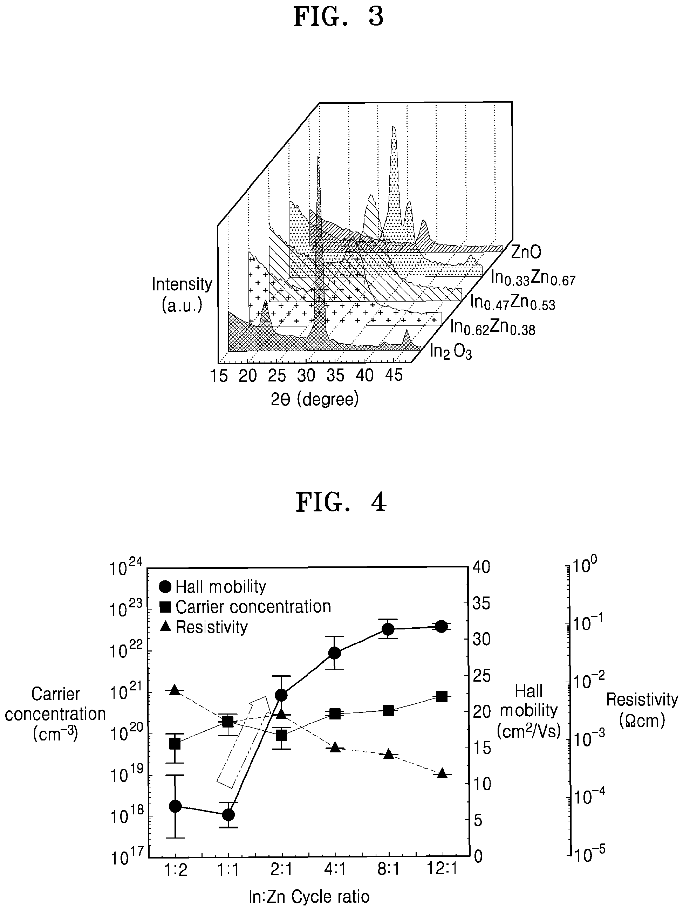

FIG. 3 is a graph showing XRD analysis results of InZnO thin films manufactured according to the In:Zn deposition cycle ratio described in Table 1.

Referring to FIG. 3, peaks showing crystallinity appear in a range where the In:Zn deposition cycle ratio is about 1:1 or more and about 8:1 or less. In this case, the peaks showing crystallinity were found at a 2-theta value between approximately 32.3 degrees and 33.3 degrees.

When forming an InZnO oxide semiconductor thin film by co-depositing In and Zn by an ALD process, a crystalline InZnO thin film may be obtained when a ratio of a deposition cycle of In to a deposition cycle of Zn is about 1 or more (for example, about 1.5 or more, for example, about 2 or more) and about 8 or less (for example, about 6 or less, for example, about 5 or less, for example, about 4 or less). In addition, when the content of In of In and Zn in the InZnO oxide semiconductor thin film is about 30 at% or more (for example, about 32 at% or more, for example, about 33 at% or more, for example, about 35 at% or more) and about 75 at% or less (for example, about 70 at% or less, for example, about 65 at% or less) , the InZnO oxide semiconductor thin film has crystallinity.

FIG. 4 shows a change in carrier concentration, Hall mobility, and resistivity of InZnO oxide semiconductor thin films manufactured according to the In:Zn deposition cycle ratio described in Table 1.

Referring to FIG. 4, as the content of In increases, the carrier concentration increases and the resistivity decreases. The Hall mobility increases as the content of In increases, and the Hall mobility increases rapidly when the deposition cycle ratio changes from 1:1 to 2:1. This may be regarded as an effect of the crystallinity of the InZnO oxide semiconductor.

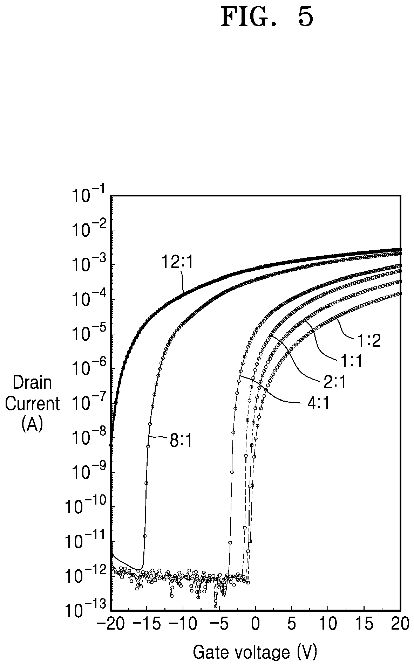

FIG. 5 is a graph showing I-V characteristics of transistors in which InZnO oxide semiconductor thin films manufactured according to the In:Zn deposition cycle ratio shown in Table 1 are used as a channel.

Referring to FIG. 5, as the content of In increases while the In:Zn deposition cycle ratio changes from 1:2 to 8:1, a threshold voltage decreases and the Hall mobility increases.

As described above, the crystalline InZnO oxide semiconductor has an content of In that is about 30 at% or more (for example, about 32 at% or more, for example, about 33 at% or more, for example, about 35 at% or more) and about 75 at% or less (for example, about 70 at% or less, for example, about 65 at% or less) among In and Zn in ICP-MS analysis, and may have a peak showing crystallinity at a 2-theta value between about 32.3 degrees and about 33.3 degrees in XRD analysis.

The crystalline InZnO oxide semiconductor may be formed by adjusting the In:Zn elementary composition ratio by changing the In:Zn deposition cycle ratio at a certain process temperature by using an ALD process. In detail, the crystalline InZnO oxide semiconductor may be formed by making the ratio of In deposition cycle to Zn deposition cycle about 1 or more (for example, about 1.5 or more, for example, about 2 or more) and about 8 or less (for example, about 6 or less, for example, about 5 or less, for example, about 4 or less) at a process temperature about 200 °C or more and about 350 °C or less (for example, about 300 °C or less) by using an ALD process. By using the crystalline InZnO oxide semiconductor as above as a channel material, Hall mobility may be increased and the subthreshold swing may be reduced, and accordingly, a semiconductor device (transistor) having excellent characteristics may be implemented.

Hereinafter, a semiconductor device (transistor) using the above-described crystalline InZnO thin film as a channel will be described.

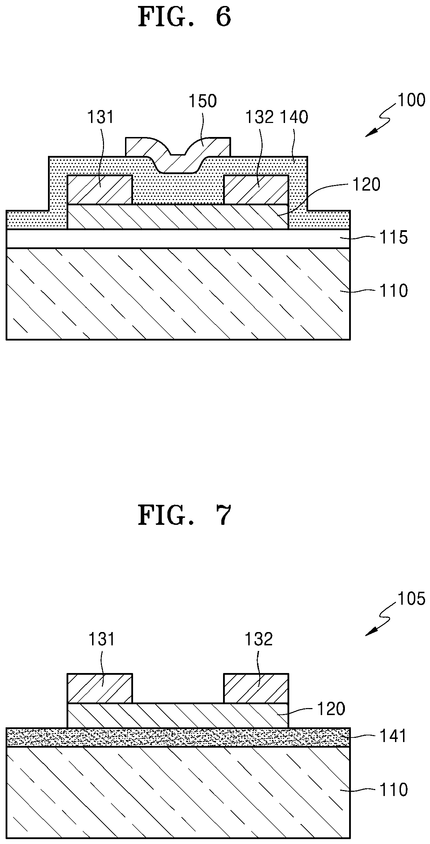

FIG. 6 illustrates a semiconductor device 100 according to an embodiment. The semiconductor device 100 illustrated in FIG. 7 may include a transistor having a top gate structure.

Referring to FIG. 6, a channel layer 120 is provided on a substrate 110. The substrate 110 may include, for example, an insulating substrate or a semiconductor substrate. The semiconductor substrate may include, for example, silicon (Si), germanium (Ge), SiGe or a III-V group semiconductor material. An insulating layer 115 such as a silicon oxide layer may be formed on a surface of the substrate 110. The substrate 110 may further include an impurity region due to doping, an electronic element such as a transistor, or a periphery circuit or the like.

The channel layer 120 is provided on an upper surface of the insulating layer 115. The channel layer 120 may be arranged in parallel to the surface of the substrate 110. The channel layer 120 may include an oxide semiconductor. In detail, the channel layer 120 may include a crystalline InZnO oxide semiconductor. The crystalline InZnO oxide semiconductor may have a certain In:Zn elementary composition ratio. In detail, in results of ICP-MS analysis of the crystalline InZnO oxide semiconductor, the content of In among In and Zn may be about 30 at% or more (for example, about 32 at% or more, for example, about 33 at% or more, for example, about 35 at% or more) and about 75 at% or less (for example, about 70 at% or less, for example, about 65 at% or less), and in XRD analysis of the crystalline InZnO oxide semiconductor, peaks showing crystallinity at a 2-theta value between about 32.3 degrees to about 33.3 degrees may appear.

As described above, the crystalline InZnO oxide semiconductor may be formed by adjusting the In:Zn elementary composition ratio by changing the In:Zn deposition cycle ratio in a co-deposition process of In and Zn by using an ALD process. In detail, a crystalline InZnO thin film may be formed by setting the ratio of the deposition cycle of In to the deposition cycle of Zn to about 1 or more (for example, about 1.5 or more, for example, about 2 or more) and about 8 or less (for example, about 6 or less, for example, about 5 or less, for example, about 4 or less) at a process temperature of about 200 °C or more and about 350 °C or less (for example, about 300 °C or less).

First and second electrodes 131 and 132 are provided on both sides of the channel layer 120, respectively. One of the first and second electrodes 131 and 132 may be a source electrode, and the other may be a drain electrode. The first and second electrodes 131 and 132 may each include a metal material. For example, the first and second electrodes 131 and 132 may include at least one selected from among tungsten (W), cobalt (Co), nickel (Ni), iron (Fe), titanium (Ti), molybdenum (Mo), chromium (Cr), zirconium (Zr), hafnium(Hf), niobium(Nb), tantalum(Ta), silver (Ag), gold (Au), aluminum (Al), copper (Cu), tin (Sb), vanadium (V), ruthenium (Ru), platinum (Pt), zinc (Zn), and magnesium (Mg).

A gate electrode 150 is provided above the channel layer 120 between the first and second electrodes 131 and 132. The gate electrode 150 may include an electrically conductive material such as metal or metal nitride. Also, the gate electrode 150 may include, for example, a transparent conductive oxide (TCO) such as indium tin oxide (ITO). A gate insulating layer 140 may be provided between the channel layer 120 and the gate electrode 150. The gate insulating layer 140 may include, for example, at least one oxide selected from among Hf, Zr, Al, and Si. However, the disclosure is not limited thereto. The gate insulating layer 140 may include at least one oxide including at least one of Hf, Zr, Al, and Si. The gate insulating layer 140 may include at least one of an oxide including Hf, an oxide including Zr, an oxide including Al, and an oxide including Si.

According to the present embodiment, the semiconductor device 100 having excellent characteristics such as high Hall mobility and a low subthreshold swing may be implemented by forming the channel layer 120 by using a crystalline InZnO oxide semiconductor.

In the above, a transistor having a top gate structure in which the gate electrode 150 is disposed above the channel layer 120 has been described, but the present embodiment is not limited thereto, and may also be applied to a transistor having a bottom gate structure in which the gate electrode 150 is disposed under the channel layer 120. A channel including a crystalline InZnO oxide semiconductor may be applied to transistors of other structures than the above-described structures.

For example, FIG. 7 illustrates a semiconductor device according to an embodiment.

Referring to FIG. 7, a semiconductor device 105 may be similar to the semiconductor device 100 in FIG. 6, except the semiconductor device 105 may have a bottom gate structure. A gate insulating layer 141 may be formed on an upper surface of the substrate 110. The gate insulating layer 141 may include, for example, at least one oxide selected from among Hf, Zr, Al, and Si. However, the disclosure is not limited thereto. The channel layer 120 may be formed on the gate insulating layer 141. A gate electrode may be provided in the substrate 110 below the gate insulating layer 141 such that the gate insulating layer 141 extends between the channel layer 120 and the gate electrode. The first and second electrodes 131 and 132 may be spaced apart from each other on top of the channel layer 120.

According to the embodiments above, a crystalline InZnO oxide semiconductor may be formed in a certain elementary composition ratio range of In and Zn. In detail, the crystalline InZnO oxide semiconductor may have a content of In that is about 30 at% or more (for example, about 32 at% or more, for example, about 33 at% or more, for example, about 35 at% or more) and about 75 at% or less (for example, about 70 at% or less, for example, about 65 at% or less) among In and Zn in ICP-MS analysis, and have a peak showing crystallinity at a 2-theta value between about 32.3 degrees and about 33.3 degrees in XRD analysis.

The crystalline InZnO oxide semiconductor may be formed by adjusting the In:Zn deposition cycle ratio at a certain process temperature by using an ALD process. In detail, the crystalline InZnO oxide semiconductor may be formed by making the ratio of the deposition cycle In to the deposition cycle of Zn about 1 or more (for example, about 1.5 or more, for example, about 2 or more) and about 8 or less (for example, about 6 or less, for example, about 5 or less, for example, about 4 or less) at a process temperature of about 200 °C or more and about 350 °C or less (for example, about 300 °C or less) in an ALD process.

When such a crystalline InZnO oxide semiconductor is used as a channel material, since Hall mobility may increase and a subthreshold swing may decrease, a semiconductor device having excellent characteristics may be implemented. The InZnO oxide semiconductor is a transparent semiconductor material having a wide bandgap of about 3.0 eV or more and may be used for an electronic device, such as a memory device or a logic device as well as a display driving device.

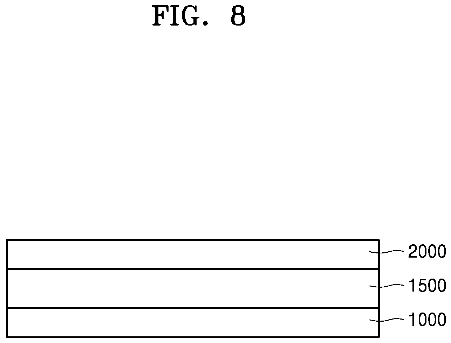

For example, FIG. 8 illustrates an electronic device including a semiconductor device according to an embodiment.

Referring to FIG. 8, the electronic device may include an intermediate layer 1500 between a first substrate 1000 and a second substrate 2000. The first substrate 1000 may be an array substrate including a semiconductor device according to example embodiments, for example, at least one of the semiconductor devices 100 and 105 in FIGS. 6 and 7, which may act as a switching device or a driving device.

The electronic device may be a display device in some embodiments. A configuration of the intermediate layer 1500 may vary according to a type of the display device. When the display device is an organic light-emitting display device, the intermediate layer 1500 may include an "organic light-emitting layer". The second substrate 2000 may include a transparent insulating material, such as silicon oxide.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the following claims.

## Claims

1. A crystalline InZnO oxide semiconductor comprising:
an oxide including In and Zn,
wherein, in Inductively Coupled Plasma-Mass Spectrometry (ICP-MS) analysis, a content of In among In and Zn is 30 at% or more and 75 at % or less, and
in an X-ray diffraction (XRD) analysis, the crystalline InZnO oxide semiconductor has a peak showing crystallinity at a 2-theta value between 32.3 degrees and 33.3 degrees.

2. The crystalline InZnO oxide semiconductor of claim 1, wherein
a content of In among In and Zn is 32 at% or more.

3. The crystalline InZnO oxide semiconductor of claims 1 or 2, wherein
a content of In among In and Zn is 33 at% or more.

4. The crystalline InZnO oxide semiconductor of any of claims 1-3, wherein
a content of In among In and Zn is 35 at% or more.

5. The crystalline InZnO oxide semiconductor of any of claims 1-4, wherein a content of In among In and Zn is 70 at% or less; and/or
wherein a content of In among In and Zn is 65 at% or more.

6. A method of forming a crystalline InZnO oxide semiconductor, the method comprising:
co-depositing In and Zn on a substrate using atomic layer deposition (ALD), wherein
a ratio of a deposition cycle of In with respect to a deposition cycle of Zn is 1 or more and 8 or less, and
in an X-ray diffraction (XRD) analysis, the crystalline InZnO oxide semiconductor has a peak showing crystallinity at a 2-theta value between 32.3 degrees and 33.3 degrees.

7. The method of claim 6, wherein,
a ratio of a deposition cycle of In with respect to a deposition cycle of Zn is 1.5 or more, preferably 2 or more.

8. The method of claims 6 or 7, wherein,
a ratio of a deposition cycle of In with respect to a deposition cycle of Zn is 6 or less.

9. The method of any of claims 6-8, wherein,
a ratio of a deposition cycle of In with respect to a deposition cycle of Zn is 5 or less.

10. The method of any of claims 6-9, wherein,
a ratio of a deposition cycle of In with respect to a deposition cycle of Zn is 4 or less.

11. The method of any of claims 6-10, wherein,
in Inductively Coupled Plasma-Mass Spectrometry (ICP-MS) analysis of the crystalline InZnO oxide semiconductor, a content of In among In and Zn is 30 at% or more and 75 at % or less.

12. The method of any of claims 6-11, wherein,
the co-depositing the In and Zn on the substrate is performed using a co-deposition process where a temperature of the substrate is 200 °C or more and 350 °C or less, preferably 200 °C or more and 300 °C or less

13. A semiconductor device comprising:
a substrate;
a channel layer on the substrate, the channel layer including the crystalline InZnO oxide semiconductor of any of claims 1-5;
a gate electrode on the channel layer; and
a source electrode and a drain electrode on both sides of the channel layer, respectively.

14. The semiconductor device of claim 13, further comprising:
a gate insulating layer between the channel layer and the gate electrode.

15. The semiconductor device of claims 13 or 14, wherein the channel layer is parallel to the substrate;
preferably wherein the gate electrode is above the channel layer or the gate electrode is under the channel layer.
